# EUROPEAN PATENT APPLICATION

(11) **EP 2 560 190 A1**
(43) Date of publication of application: **20.02.2013**
(21) Application number: 11839646.4
(22) Date of filing: 07.11.2011
(51) Int. Cl.: H01L 21/02, H01L 27/12

(54) **GROUP III NITRIDE COMPOSITE SUBSTRATE**

(30) Priority: 27.09.2011 JP 2011210704; 12.11.2010 JP 2010253645
(71) Applicant: Sumitomo Electric Industries, Ltd., Chuo-ku Osaka-shi Osaka 541-0041 (JP)
(72) Inventor: SATOH, Issei, Itami-shi Hyogo 664-0016 (JP); YOSHIDA, Hiroaki, Itami-shi Hyogo 664-0016 (JP); YAMAMOTO, Yoshiyuki, Itami-shi Hyogo 664-0016 (JP); HACHIGO, Akihiro, Itami-shi Hyogo 664-0016 (JP); MATSUBARA, Hideki, Itami-shi Hyogo 664-0016 (JP)
(74) Representative: Grünecker, Kinkeldey, Stockmair & Schwanhäusser
(86) International application number: PCT/JP2011/075591
(87) International publication number: WO 2012/063774

(57) **Abstract**

A group III nitride composite substrate (1) includes a support substrate (10), an oxide film (20) formed on the support substrate (10), and a group III nitride layer (30a) formed on the oxide film (20). The oxide film (20) may be a film selected from the group consisting of a TiO₂ film and a SrTiO₃ film, and an impurity may be added to the oxide film. Accordingly, the group III nitride composite substrate having a high bonding strength between the support substrate and the group III nitride layer is provided.

## Description

### TECHNICAL FIELD

The present invention relates to a group III nitride composite substrate including a support substrate and a group III nitride layer and having a high bonding strength between an oxide film and the group III nitride layer.

### BACKGROUND ART

A group III nitride substrate such as AlₓIn_{y}Ga_{1-x-y}N substrate (0≤x, 0≤y, x+y≤1) that is used suitably for a semiconductor device is high in terms of the cost of manufacture. Accordingly, the semiconductor device for which such a group III nitride substrate is used requires a high cost of manufacture.

In view of the above, a substrate to be used for a semiconductor device has been proposed that is a group III nitride composite substrate of a relatively low cost in which a thin group III nitride layer is formed on a support substrate, instead of an expensive thick group III nitride substrate. For example, Japanese Patent Laying-Open No. 2006-210660 (PTL 1) discloses a method for manufacturing a semiconductor substrate in which a nitride semiconductor film such as GaN or AlN is formed on a silicon substrate or the like.

### CITATION LIST

### PATENT LITERATURE

PTL 1: Japanese Patent Laying-Open No. 2006-210660

### SUMMARY OF INVENTION

### TECHNICAL PROBLEM

The semiconductor substrate disclosed in Japanese Patent Laying-Open No. 2006-210660 (PTL 1), however, has a problem that, because the group III nitride layer is directly laid on and bonded to the silicon substrate or the like which is a support substrate, the bonding strength is weak.

An object of the present invention is therefore to provide a group III nitride composite substrate having a high bonding strength between the support substrate and the group III nitride layer.

### SOLUTION TO PROBLEM

According to an aspect, the present invention is a group III nitride composite substrate including a support substrate, an oxide film formed on the support substrate, and a group III nitride layer formed on the oxide film.

In the group III nitride composite substrate of the present invention, the oxide film may be a film selected from the group consisting of a TiO₂ film and a SrTiO₃ film. An impurity may be added to the oxide film. Here, the impurity may include at least one element selected from the group consisting of Nb and La. The support substrate may be a group III nitride support substrate. Alternatively, the support substrate may be a sapphire support substrate.

### ADVANTAGEOUS EFFECTS OF INVENTION

In accordance with the present invention, a group III nitride composite substrate having a high bonding strength between a support substrate and a group III nitride layer is provided.

### BRIEF DESCRIPTION OF DRAWINGS

Fig. 1 is a schematic cross section showing an example of the group III nitride composite substrate according to the present invention.
Fig. 2 is a schematic cross section showing an example of the method for manufacturing a group III nitride composite substrate according to the present invention.

### DESCRIPTION OF EMBODIMENTS

### [Group III Nitride Composite Substrate]

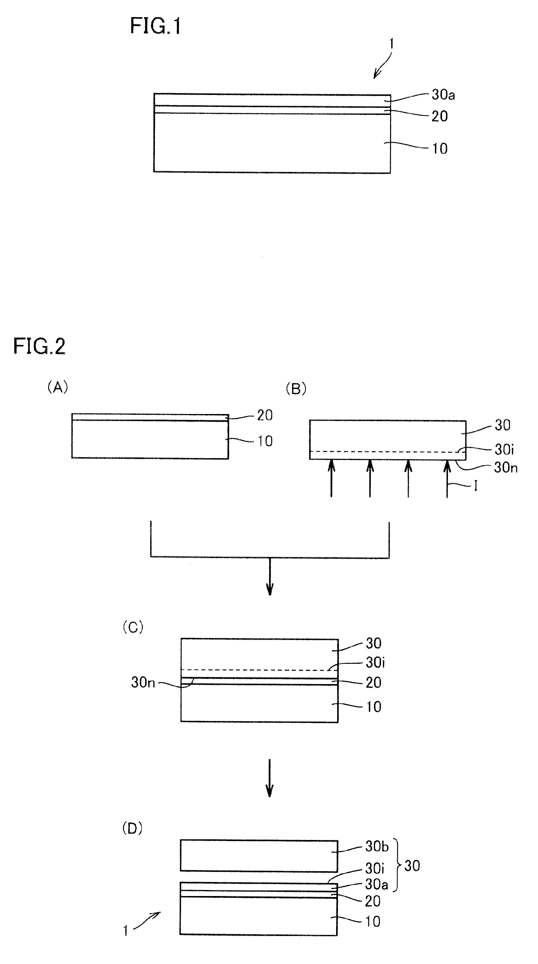

Referring to Fig. 1, a group III nitride composite substrate 1 in an embodiment of the present invention includes a support substrate 10, an oxide film 20 formed on support substrate 10, and a group III nitride layer 30a formed on oxide film 20. Group III nitride composite substrate 1 of the present embodiment has a significantly high bonding strength between support substrate 10 and group III nitride layer 30a since support substrate 10 and group III nitride layer 30a are bonded to each other with oxide film 20 interposed therebetween.

### Support Substrate

Support substrate 10 is not particularly limited as long as oxide film 20 can be formed on the support substrate. Preferred examples of the support substrate are sapphire support substrate, Si support substrate, SiC support substrate, group III nitride support substrate, and the like. Here, in order to reduce the difference in thermal expansion coefficient between the support substrate and the group III nitride layer in the group III nitride composite substrate, the group III nitride support substrate is preferred. The group III nitride support substrate may be a monocrystalline body, a polycrystalline body such as non-oriented polycrystal body (sintered body for example) or oriented polycrystal body, or an amorphous body. In order to reduce the cost of manufacture, the support substrate is preferably a polycrystalline body or an amorphous body. In order to improve the light transmissivity of the group III nitride composite substrate, the sapphire support substrate is preferred.

Further, the thickness of support substrate 10 is not particularly limited as long as the thickness enables oxide film 20 and group III nitride layer 30a to be supported. For the sake of ease of handling, a thickness of 300 µm or more is preferred. For the sake of reducing the cost of materials, a thickness of 1000 µm or less is preferred.

### Oxide Film

Oxide film 20 is not particularly limited as long as the oxide film satisfies the conditions: group III nitride layer 30a can be formed on the oxide film; the oxide film can be formed on support substrate 10; and the oxide film provides a high bonding strength between support substrate 10 and group III nitride layer 30a. Preferred examples of the oxide film are TiO₂ film, SrTiO₃ film, Ga₂O₃ film, Al₂O₃ film, and the like. In order to increase the transmissivity of light from the group III nitride layer, the oxide film is preferably a high-refractive-index oxide film which is for example a film selected from the group consisting of TiO₂ film (refractive index: about 2.8) and SrTiO₃ film (refractive index: about 2.4).

Further, in order to give electrical conductivity, an impurity is preferably added to oxide film 20. Here, in order to increase the electrical conductivity and increase the bonding strength between support substrate 10 and group III nitride layer 30a, the impurity preferably includes at least one element selected from the group consisting of Nb and La, for example. Further, in terms of high effectiveness of the added impurity in increasing the electrical conductivity and the bonding strength, the impurity may include any of Sb, Mo, Fe, Al, Sn, Pt, I, B, N, and the like. The concentration of the impurity contained in oxide film 20 is not particularly limited. In order to increase the electrical conductivity, the concentration is preferably 0.01 mass% or more. In order to increase the light transmissivity, the concentration is preferably 1 mass% or less.

Further, the thickness of oxide film 20 is not particularly limited as long as the thickness allows the bonding strength between support substrate 10 and group III nitride layer 30a to be increased. In order to increase the bonding strength, the thickness is preferably 50 nm or more. In order to reduce the cost of forming the film, the thickness is preferably 1000 nm or less.

### Group III Nitride Layer

Group III nitride layer 30a refers to a layer formed of a group III nitride such as AlₓIn_{y}Ga₁₋ₓ₋yN (0≤x, 0≤y, x+y≤1). Group III nitride layer 30a is preferably a monocrystalline body in order to allow a highly-crystalline epitaxial layer to be grown on the group III nitride layer.

The thickness of group III nitride layer 30a is not particularly limited as long as the thickness enables a highly-crystalline epitaxial layer to be grown on the group III nitride layer. In order to form group III nitride layer 30a without causing it to be cracked, the thickness is preferably 100 nm or more. In order to enhance the precision of the thickness of group III nitride layer 30a and prevent the crystallinity from being degraded due to ion implantation, the thickness is preferably 1000 µm or less.

### [Method for Manufacturing Group III Nitride Composite Substrate]

Referring to Fig. 2, a method for manufacturing group III nitride composite substrate 1 of the present embodiment is not particularly limited and includes, for example, the step of preparing support substrate 10 and forming oxide film 20 on this support substrate 10 (Fig. 2 (A)), and the step of forming group III nitride layer 30a on oxide film 20 formed on support substrate 10 to thereby obtain the group III nitride composite substrate (Fig. 2 (B) to Fig. 2 (D)). This manufacturing method can be used to efficiently obtain the group III nitride composite substrate in which the bonding strength between support substrate 10 and group III nitride layer 30a is high.

Referring to Fig. 2 (A), the step of preparing support substrate 10 and forming oxide film 20 on this support substrate 10 may include the sub-step of preparing support substrate 10 and the sub-step of forming oxide film 20 on support substrate 10.

In the sub-step of preparing support substrate 10, support substrate 10 may be prepared by a common method appropriate for the material and the shape of the support substrate. For example, the group III nitride support substrate may be prepared by processing into a predetermined shape a group III nitride crystal body obtained by a vapor phase method such as HVPE (hydride vapor phase epitaxy) or sublimation method, or a liquid phase method such as flux method or high nitrogen pressure solution growth. The sapphire support substrate may be prepared by processing a sapphire crystal into a predetermined shape.

In the sub-step of forming oxide film 20 on support substrate 10, the method for forming oxide film 20 on support substrate 10 is not particularly limited as long as the method is appropriate for forming this oxide film 20. A common method such as sputtering, pulsed laser deposition, molecular beam epitaxy, electron beam vapor deposition, or chemical vapor deposition may be used.

Referring to Fig. 2 (B) to Fig. 2 (D), the step of forming group III nitride layer 30a on oxide film 20 formed on support substrate 10 to thereby obtain group III nitride composite substrate 1 may include the sub-step of implanting ion I to a region of a certain depth from a main surface 30n in a group III nitride substrate 30 (Fig. 2 (B)), the sub-step of attaching, onto oxide film 20 formed on support substrate 10, main surface 30n located on an ion implantation region 30i (region where ions are implanted, which is applied as well to the following description) side of group III nitride substrate 30 (Fig. 2 (C)), and the sub-step of separating group III nitride substrate 30 into group III nitride layer 30a and a remaining group III nitride substrate 30b along ion implantation region 30i to form group III nitride layer 30a on oxide film 20 formed on support substrate 10 (Fig. 2 (D)).

In the sub-step of implanting ion I to a region of a certain depth from main surface 30n in group III nitride substrate 30 shown in Fig. 2 (B), the depth to which the ion is implanted is not particularly limited and is preferably not less than 100 nm and not more than 1000 µm. If the depth to which the ion is implanted is less than 100 nm, group III nitride layer 30a, which is formed by separating group III nitride substrate 30 along its ion implantation region 30i, is likely to crack. If the depth is larger than 1000 µm, a broad ion distribution is generated, which makes it difficult to adjust the depth at which the substrate is separated and thus makes it difficult to adjust the thickness of group III nitride layer 30a. Further, the type of the ion to be implanted is not particularly limited. In order to prevent degradation of the crystallinity of the group III nitride layer to be formed, light-mass ion is preferred. For example, hydrogen ion, helium ion, or the like is preferred. Ion implantation region 30i thus formed is embrittled due to the implanted ion.

In the sub-step of attaching, onto oxide film 20 formed on support substrate 10, main surface 30n located on ion implantation region 30i side of group III nitride substrate 30 shown in Fig. 2 (C), the method for attaching it is not particularly limited. In order that the bonding strength may be kept even in a high-temperature atmosphere after it is attached, a method such as the direct bonding method according to which the surfaces to be attached to each other are cleaned and directly attached to each other, and thereafter increased in temperature to approximately 600°C to 1200°C so that they are bonded together, or the surface-activated method according to which the surfaces to be attached to each other are activated by plasma, ion or the like and bonded together at a low temperature from approximately room temperature (25°C for example) to 400°C, is preferred.

In the sub-step of separating group III nitride substrate 30 into group III nitride layer 30a and remaining group III nitride substrate 30b along ion implantation region 30i to form group III nitride layer 30a on oxide film 20 formed on support substrate 10 shown in Fig. 2 (D), the method for separating group III nitride substrate 30 along its ion implantation region 30i is not particularly limited as long as the method applies certain energy to ion implantation region 30i of group III nitride substrate 30. At least any of the method of applying stress to ion implantation region 30i, the method of applying heat thereto, the method of applying light thereto, and the method of applying ultrasonic waves thereto may be used. Since this ion implantation region 30i has been embrittled due to the implanted ion, group III nitride substrate 30 receives the above-described energy to be easily separated into group III nitride layer 30a attached onto oxide film 20 formed on support substrate 10, and remaining group III nitride substrate 30b.

In this way, group III nitride layer 30a is formed on oxide film 20 on support substrate 10 to thereby obtain group III nitride composite substrate 1 including support substrate 10, oxide film 20 formed on support substrate 10, and group III nitride layer 30a formed on oxide film 20.

Regarding the above-described method for manufacturing a group III nitride composite substrate, the description has been given of the case where the ion implantation method is used to form group III nitride layer 30a. The group III nitride layer, however, may also be formed by attaching a group III nitride substrate in which no ion is implanted, to the oxide film formed on the support substrate, and thereafter separating the group III nitride crystal along a plane at a predetermined depth from the attached main surface of the group III nitride crystal. In this case, the method for separating the group III nitride substrate is not particularly limited, and a method such as cutting by means of a wire saw, inner-diameter blade, outer-diameter blade, or the like may be used.

### [Examples]

### Examples A1-A10

### 1. Preparation of Support Substrate

Referring to Fig. 2 (A), ten substrates having a diameter of 50 mm and a thickness of 500 µm were cut from a GaN crystal (not shown) grown by means of HVPE, and respective main surfaces were polished to prepare ten GaN support substrates (support substrates 10).

### 2. Formation of Oxide Film on Support Substrate

Referring to Fig. 2 (A), sputtering was used to grow, on the ten GaN support substrates (support substrates 10), ten different TiO₂ films (oxide films 20) having a thickness of 300 nm, respectively. Here, the ten different TiO₂ films were: a TiO₂ film to which no impurity was added (Example A1); a TiO₂ film to which 0.01 mass% of Nb was added (Example A2); a TiO₂ film to which 0.01 mass% of La was added (Example A3); a TiO₂ film to which 0.01 mass% ofNb and 0.01 mass% of La were added (Example A4); a TiO₂ film to which 0.1 mass% ofNb was added (Example A5); a TiO₂ film to which 0.1 mass% of La was added (Example A6); a TiO₂ film to which 0.1 mass% of Nb and 0.1 mass% of La were added (Example A7); a TiO₂ film to which 1 mass% of Nb was added (Example A8); a TiO₂ film to which 1 mass% of La was added (Example A9); and a TiO₂ film to which 1 mass% ofNb and 1 mass% of La were added (Example A10). The results are summarized in Table 1.

### 3. Formation of Group III Nitride Layer on Oxide Film

Referring to Fig. 2 (B), ten substrates having a diameter of 50 mm and a thickness of 500 µm were cut from a GaN crystal (not shown) grown by means of HVPE, respective main surfaces were polished to prepare ten GaN substrates (group III nitride substrates 30), and hydrogen ions were implanted to a depth of 300 nm from main surface 30n of each substrate.

Referring to Fig. 2 (C), respective main surfaces of the TiO₂ films (oxide films 20) on the ten GaN support substrates (support substrates 10) and respective main surfaces 30n on the ion implantation side of the ten GaN substrates (group III nitride substrates 30) were purified with an argon plasma, and thereafter attached with a bonding pressure of 8 MPa, respectively.

Referring to Fig. 2 (D), the resultant ten substrates that were each formed by attaching them to each other were heat-treated at 300°C for two hours to thereby increase the bonding strength of the substrates each formed by attaching them to each other. Further, the GaN substrate (group III nitride substrate) was separated along its ion implantation region 30i to thereby form a GaN layer (group III nitride layer 30a) having a thickness of 300 nm on the TiO₂ film (oxide film 20). Thus, ten group III nitride composite substrates 1 in which respective GaN support substrates (support substrates 10), respective TiO₂ films (oxide films 20), and respective GaN layers (group III nitride layers 30a) were formed in this order were obtained.

### 4. Measurement of Bonding Strength between Support Substrate and Group III Nitride Layer

From each of the ten group III nitride composite substrates 1 thus obtained, five samples having a size of the main surface of 12 mm x 12 mm were prepared. The GaN support substrate (support substrate 10) and the GaN layer (group III nitride layer 30a) of each sample were fixed to a measurement jig with an epoxy adhesive. At an atmosphere temperature of 25°C and a tension rate of 0.1 mm/sec, the bonding strength between the GaN support substrate (support substrate 10) and the TiO₂ film (oxide film 20) and the GaN layer (group III nitride layer 30a) at the time the sample was ruptured or broken was measured. The samples were all ruptured or broken at the bonding interface between the TiO₂ film (oxide film 20) and the GaN layer (group III nitride layer 30a). This bonding strength is expressed as a relative bonding strength in the following way. The average of respective bonding strengths of the five samples obtained from one group III nitride composite substrate was measured. The average of respective bonding strengths was also measured of five samples of Comparative Example R1 described below (an example where a GaN support substrate (support substrate 10) and a GaN layer (group III nitride layer 30a) were directly attached to each other without TiO₂ film (oxide film 20) interposed therebetween) (the bonding strength average of Comparative Example R1 is expressed as 1). The relative bonding strength is the average bonding strength of the Example relative to that of Comparative Example R1. The results are summarized in Table 1.

### Comparative Example R1

### 1. Preparation of Support Substrate

In a similar manner to Example A1, one GaN support substrate (support substrate) was prepared.

### 2. Formation of Group III Nitride Layer on Support Substrate

In a similar manner to Example A1, one GaN substrate (group III nitride substrate) was prepared and hydrogen ions were implanted to a depth of 300 nm from a main surface of the GaN substrate.

Subsequently, a main surface of the GaN support substrate (support substrate) and the main surface on the ion implantation side of the GaN substrate (group III nitride substrate) were purified with an argon plasma and thereafter attached to each other with a bonding strength of 8 MPa.

Subsequently, the substrate obtained by attaching them to each other was heat-treated at 300°C for two hours to thereby increase the bonding strength of the substrate obtained by attaching them to each other. Further, the GaN substrate (group III nitride substrate) was separated along its ion implantation region to thereby obtain a group III nitride composite substrate in which the GaN layer (group III nitride layer) having a thickness of 300 nm was directly formed on the GaN support substrate (group III nitride support substrate).

### 3. Measurement of Bonding Strength between Support Substrate and Group III Nitride Layer

In a similar manner to Example A1, the bonding strength between the support substrate and the group III nitride layer in the obtained group III nitride composite substrate was measured. The samples were all ruptured at the bonding interface between the GaN support substrate (support substrate) and the GaN layer (group III nitride layer). The results are summarized in Tables 1 and 2.

**Table 1**

| | support substrate | oxide film | | | group III nitride layer | relative bonding strength |
|---|---|---|---|---|---|---|
| | | type | Nb concentration (mass%) | La concentration (mass%) | | |
| Comparative Example R1 | GaN | - | - | - | GaN | 1 |
| Example A1 | GaN | TiO₂ | 0 | 0 | GaN | 980 |
| Example A2 | GaN | TiO₂ | 0.01 | 0 | GaN | 1000 |
| Example A3 | GaN | TiO₂ | 0 | 0.01 | GaN | 990 |
| Example A4 | GaN | TiO₂ | 0.01 | 0.01 | GaN | 1019 |
| Example A5 | GaN | TiO₂ | 0.1 | 0 | GaN | 1078 |
| Example A6 | GaN | TiO₂ | 0 | 0.1 | GaN | 1058 |
| Example A7 | GaN | TiO₂ | 0.1 | 0.1 | GaN | 1372 |
| Example A8 | GaN | TiO₂ | 1 | 0 | GaN | 1568 |
| Example A9 | GaN | TiO₂ | 0 | 1 | GaN | 1470 |
| Example A10 | GaN | TiO₂ | 1 | 1 | GaN | 1764 |

Referring to Table 1, the group III nitride composite substrates (Examples A1 to A10) in which the GaN support substrate (support substrate) and the GaN layer (group III nitride layer) were bonded to each other with the TiO₂ film (oxide film) interposed therebetween had a significantly larger bonding strength than the group III nitride composite substrate (Comparative Example R1) in which the GaN support substrate (support substrate) and the GaN layer (group III nitride layer) were directly bonded to each other without TiO₂ film (oxide film) interposed therebetween. Further, the group III nitride composite substrates (Examples A2 to A10) each having the TiO₂ film (oxide film) to which at least one of elements Nb and La was added as an impurity had a larger bonding strength than the group III nitride composite substrate (Example A1) having the TiO₂ film (oxide film) to which no impurity was added.

### Examples B1-B10

### 1. Preparation of Support Substrate

In a similar manner to Examples A1 to A10, ten GaN support substrates (support substrates) were prepared.

### 2. Formation of Oxide Film on Support Substrate

Sputtering was used to grow, on the ten GaN support substrates (support substrates), ten different SrTiO₃ films (oxide films) having a thickness of 300 nm, respectively. Here, the ten different SrTiO₃ films were: a SrTiO₃ film to which no impurity was added (Example B1); a SrTiO₃ film to which 0.01 mass% of Nb was added (Example B2); a SrTiO₃ film to which 0.01 mass% of La was added (Example B3); a SrTiO₃ film to which 0.01 mass% of Nb and 0.01 mass% of La were added (Example B4); a SrTiO₃ film to which 0.1 mass% ofNb was added (Example B5); a SrTiO₃ film to which 0.1 mass% of La was added (Example B6); a SrTiO₃ film to which 0.1 mass% of Nb and 0.1 mass% of La were added (Example B7); a SrTiO₃ film to which 1 mass% of Nb was added (Example B8); a SrTiO₃ film to which 1 mass% of La was added (Example B9); and a SrTiO₃ film to which 1 mass% of Nb and 1 mass% of La were added (Example B10). The results are summarized in Table 2.

### 3. Formation of Group III Nitride Layer on Oxide Film

In a similar manner to Examples A1 to A10, on respective SrTiO₃ films (oxide films) on the ten GaN support substrates (support substrates), GaN layers (group III nitride layers) having a thickness of 300 nm were formed respectively. Thus, ten group III nitride composite substrates in which respective GaN support substrates (support substrates), respective SrTiO₃ films (oxide films), and respective GaN layers (group III nitride layers) were formed in this order were prepared.

### 4. Measurement of Bonding Strength between Support Substrate and Group III Nitride Layer

For the ten group III nitride composite substrates thus obtained, in a similar manner to Examples A 1 to A10, the bonding strength between the GaN support substrate (support substrate) and the SrTiO₃ film (oxide film) and the GaN layer (group III nitride layer) at the time the sample was ruptured was measured. The samples were all ruptured at the bonding interface between the SrTiO₃ film (oxide film) and the GaN layer (group III nitride layer). This bonding strength is expressed as a relative bonding strength in the following way. The average of respective bonding strengths of the five samples obtained from one group III nitride composite substrate was measured. The average of respective bonding strengths was also measured of five samples of Comparative Example R1 (an example where a GaN support substrate (support substrate) and a GaN layer (group III nitride layer) were directly attached to each other without SrTiO₃ film (oxide film) interposed therebetween) (the bonding strength average of Comparative Example R1 is expressed as 1). The relative bonding strength is the average bonding strength of the Example relative to that of Comparative Example R1. The results are summarized in Table 2.

**Table 2**

| | support substrate | oxide film | | | group III nitride layer | relative bonding strength |
|---|---|---|---|---|---|---|
| | | type | Nb concentration (mass%) | La concentration (mass%) | | |
| Comparative Example R1 | GaN | - | - | - | GaN | 1 |
| Example B1 | GaN | SrTiO₃ | 0 | 0 | GaN | 950 |
| Example B2 | GaN | SrTiO₃ | 0.01 | 0 | GaN | 960 |
| Example B3 | GaN | SrTiO₃ | 0 | 0.01 | GaN | 969 |
| Example B4 | GaN | SrTiO₃ | 0.01 | 0.01 | GaN | 979 |
| Example B5 | GaN | SrTiO₃ | 0.1 | 0 | GaN | 1017 |
| Example B6 | GaN | SrTiO₃ | 0 | 0.1 | GaN | 1093 |
| Example B7 | GaN | SrTiO₃ | 0.1 | 0.1 | GaN | 1235 |
| Example B8 | GaN | SrTiO₃ | 1 | 0 | GaN | 1330 |
| Example B9 | GaN | SrTiO₃ | 0 | 1 | GaN | 1425 |
| Example B10 | GaN | SrTiO₃ | 1 | 1 | GaN | 1520 |

Referring to Table 2, the group III nitride composite substrates (Examples B1 to B 10) in which the GaN support substrate (support substrate) and the GaN layer (group III nitride layer) were bonded to each other with the SrTiO₃ film (oxide film) interposed therebetween had a significantly larger bonding strength than the group III nitride composite substrate (Comparative Example R1) in which the GaN support substrate (support substrate) and the GaN layer (group III nitride layer) were directly bonded to each other without SrTiO₃ film (oxide film) interposed therebetween. Further, the group III nitride composite substrates (Examples B2 to B 10) each having the SrTiO₃ film (oxide film) to which at least one of elements Nb and La was added as an impurity had a larger bonding strength than the group III nitride composite substrate (Example B 1) having the SrTiO₃ film (oxide film) to which no impurity was added.

### Examples C1-C10

### 1. Preparation of Support Substrate

Ten sapphire substrates having a diameter of 50 mm and a thickness of 500 µm and having respective polished main surfaces were prepared.

### 2. Formation of Oxide Film on Support Substrate

Sputtering was used to grow, on the ten sapphire support substrates (support substrates), ten different TiO₂ films (oxide films) having a thickness of 300 nm, respectively. Here, the ten different TiO₂ films were: a TiO₂ film to which no impurity was added (Example C1); a TiO₂ film to which 0.01 mass% of Nb was added (Example C2); a TiO₂ film to which 0.01 mass% of La was added (Example C3); a TiO₂ film to which 0.01 mass% ofNb and 0.01 mass% of La were added (Example C4); a TiO₂ film to which 0.1 mass% of Nb was added (Example C5); a TiO₂ film to which 0.1 mass% of La was added (Example C6); a TiO₂ film to which 0.1 mass% of Nb and 0.1 mass% of La were added (Example C7); a TiO₂ film to which 1 mass% of Nb was added (Example C8); a TiO₂ film to which 1 mass% of La was added (Example C9); and a TiO₂ film to which 1 mass% of Nb and 1 mass% of La were added (Example C10). The results are summarized in Table 3.

### 3. Formation of Group III Nitride Layer on Oxide Film

In a similar manner to Examples A1 to A10, on respective TiO₂ films (oxide films) on the ten GaN support substrates (support substrates), GaN layers (group III nitride layers) having a thickness of 300 nm were formed respectively. Thus, ten group III nitride composite substrates in which respective sapphire support substrates (support substrates), respective TiO₂ films (oxide films), and respective GaN layers (group III nitride layers) were formed in this order were prepared.

### 4. Measurement of Bonding Strength between Support Substrate and Group III Nitride Layer

For the ten group III nitride composite substrates thus obtained, in a similar manner to Examples A 1 to A 10, the bonding strength between the sapphire support substrate (support substrate) and the TiO₂ film (oxide film) and the GaN layer (group III nitride layer) at the time the sample was ruptured was measured. The samples were all ruptured at the bonding interface between the TiO₂ film (oxide film) and the GaN layer (group III nitride layer). This bonding strength is expressed as a relative bonding strength in the following way. The average of respective bonding strengths of the five samples obtained from one group III nitride composite substrate was measured. The average of respective bonding strengths was also measured of five samples of Comparative Example R2 described below (an example where a sapphire support substrate (support substrate) and a GaN layer (group III nitride layer) were directly attached to each other without TiO₂ film (oxide film) interposed therebetween) (the bonding strength average of Comparative Example R2 is expressed as 1). The relative bonding strength is the average bonding strength of the Example relative to that of Comparative Example R2. The results are summarized in Table 3.

### Comparative Example R2

### 1. Preparation of Support Substrate

In a similar manner to Example C1, one sapphire support substrate (support substrate) was prepared.

### 2. Formation of Group III Nitride Layer on Support Substrate

In a similar manner to Example A1, one GaN substrate (group III nitride substrate) was prepared and hydrogen ions were implanted to a depth of 300 nm from a main surface of the GaN substrate.

Subsequently, a main surface of the sapphire support substrate (support substrate) and the main surface on the ion implantation side of the GaN substrate (group III nitride substrate) were purified with an argon plasma and thereafter attached to each other with a bonding pressure of 8 MPa.

Subsequently, the substrate obtained by attaching them to each other was heat-treated at 300°C for two hours to thereby increase the bonding strength of the substrate obtained by attaching them to each other. Further, the GaN substrate (group III nitride substrate) was separated along its ion implantation region to thereby obtain a group III nitride composite substrate in which the GaN layer (group III nitride layer) having a thickness of 300 nm was directly formed on the sapphire support substrate (support substrate).

### 3. Measurement of Bonding Strength between Support Substrate and Group III Nitride Layer

In a similar manner to Example A1, the bonding strength between the support substrate and the group III nitride layer in the obtained group III nitride composite substrate was measured. The samples were all ruptured at the bonding interface between the sapphire support substrate (support substrate) and the GaN layer (group III nitride layer). The results are summarized in Tables 3 and 4.

**Table 3**

| | support substrate | oxide film | | | group III relative nitride bonding layer strength | |
|---|---|---|---|---|---|---|
| | | type | Nb concentration (mass%) | La concentration (mass%) | | |
| Comparative Example R2 | sapphire | - | - | - | GaN | 1 |
| Example C1 | sapphire | TiO₂ | 0 | 0 | GaN | 930 |
| Example C2 | sapphire | TiO₂ | 0.01 | 0 | GaN | 960 |
| Example C3 | sapphire | TiO₂ | 0 | 0.01 | GaN | 949 |
| Example C4 | sapphire | TiO₂ | 0.01 | 0.01 | GaN | 967 |
| Example C5 | sapphire | TiO₂ | 0.1 | 0 | GaN | 1023 |
| Example C6 | sapphire | TiO₂ | 0 | 0.1 | GaN | 1004 |
| Example C7 | sapphire | TiO₂ | 0.1 | 0.1 | GaN | 1302 |
| Example C8 | sapphire | TiO₂ | 1 | 0 | GaN | 1488 |
| Example C9 | sapphire | TiO₂ | 0 | 1 | GaN | 1395 |
| Example C10 | sapphire | TiO₂ | 1 | 1 | GaN | 1674 |

Referring to Table 3, the group III nitride composite substrates (Examples C1 to C 10) in which the sapphire support substrate (support substrate) and the GaN layer (group III nitride layer) were bonded to each other with the TiO₂ film (oxide film) interposed therebetween had a significantly larger bonding strength than the group III nitride composite substrate (Comparative Example R2) in which the sapphire support substrate (support substrate) and the GaN layer (group III nitride layer) were directly bonded to each other without TiO₂ film (oxide film) interposed therebetween. Further, the group III nitride composite substrates (Examples C2 to C10) each having the TiO₂ film (oxide film) to which at least one of elements Nb and La was added as an impurity had a larger bonding strength than the group III nitride composite substrate (Example C1) having the TiO₂ film (oxide film) to which no impurity was added.

### Examples D1-D10

### 1. Preparation of Support Substrate

In a similar manner to Examples C1 to C10, ten sapphire support substrates (support substrates) were prepared.

### 2. Formation of Oxide Film on Support Substrate

Sputtering was used to grow, on the ten sapphire support substrates (support substrates), ten different SrTiO₃ films (oxide films) having a thickness of 300 nm, respectively. Here, the ten different SrTiO₃ films were: a SrTiO₃ film to which no impurity was added (Example D1); a SrTiO₃ film to which 0.01 mass% ofNb was added (Example D2); a SrTiO₃ film to which 0.01 mass% of La was added (Example D3); a SrTiO₃ film to which 0.01 mass% ofNb and 0.01 mass% of La were added (Example D4); a SrTiO₃ film to which 0.1 mass% of Nb was added (Example D5); a SrTiO₃ film to which 0.1 mass% of La was added (Example D6); a SrTiO₃ film to which 0.1 mass% of Nb and 0.1 mass% of La were added (Example D7); a SrTiO₃ film to which 1 mass% ofNb was added (Example D8); a SrTiO₃ film to which 1 mass% of La was added (Example D9); and a SrTiO₃ film to which 1 mass% ofNb and 1 mass% of La were added (Example D10). The results are summarized in Table 4.

### 3. Formation of Group III Nitride Layer on Oxide Film

In a similar manner to Examples A1 to A10, on respective SrTiO₃ films (oxide films) on the ten sapphire support substrates (support substrates), GaN layers (group III nitride layers) having a thickness of 300 nm were formed respectively. Thus, ten group III nitride composite substrates in which respective GaN support substrates (support substrates), respective SrTiO₃ films (oxide films), and respective GaN layers (group III nitride layers) were formed in this order were prepared.

### 4. Measurement of Bonding Strength between Support Substrate and Group III Nitride Layer

For the ten group III nitride composite substrates thus obtained, in a similar manner to Examples A 1 to A10, the bonding strength between the sapphire support substrate (support substrate) and the SrTiO₃ film (oxide film) and the GaN layer (group III nitride layer) at the time the sample was ruptured was measured. The samples were all ruptured at the bonding interface between the SrTiO₃ film (oxide film) and the GaN layer (group III nitride layer). This bonding strength is expressed as a relative bonding strength in the following way. The average of respective bonding strengths of the five samples obtained from one group III nitride composite substrate was measured. The average of respective bonding strengths was also measured of five samples of Comparative Example R2 (an example where a sapphire support substrate (support substrate) and a GaN layer (group III nitride layer) were directly attached to each other without SrTiO₃ film (oxide film) interposed therebetween) (the bonding strength average of Comparative Example R2 is expressed as 1). The relative bonding strength is the average bonding strength of the Example relative to that of Comparative Example R2. The results are summarized in Table 4.

**Table 4**

| | support substrate | oxide film | | | group III nitride layer | relative bonding strength |
|---|---|---|---|---|---|---|
| | | type | Nb concentration (mass%) | La concentration (mass%) | | |
| Comparative Example R2 | sapphire | - | - | - | GaN | 1 |
| Example D1 | sapphire | SrTiO₃ | 0 | 0 | GaN | 910 |
| Example D2 | sapphire | SrTiO₃ | 0.01 | 0 | GaN | 919 |
| Example D3 | sapphire | SrTiO₃ | 0 | 0.01 | GaN | 928 |
| Example D4 | sapphire | SrTiO₃ | 0.01 | 0.01 | GaN | 937 |
| Example D5 | sapphire | SrTiO₃ | 0.1 | 0 | GaN | 974 |
| Example D6 | sapphire | SrTiO₃ | 0 | 0.1 | GaN | 1047 |
| Example D7 | sapphire | SrTiO₃ | 0.1 | 0.1 | GaN | 1183 |
| Example D8 | sapphire | SrTiO₃ | 1 | 0 | GaN | 1274 |
| Example D9 | sapphire | SrTiO₃ | 0 | 1 | GaN | 1365 |
| Example D10 | sapphire | SrTiO₃ | 1 | 1 | GaN | 1456 |

Referring to Table 4, the group III nitride composite substrates (Examples D 1 to D10) in which the sapphire support substrate (support substrate) and the GaN layer (group III nitride layer) were bonded to each other with the SrTiO₃ film (oxide film) interposed therebetween had a significantly larger bonding strength than the group III nitride composite substrate (Comparative Example R2) in which the sapphire support substrate (support substrate) and the GaN layer (group III nitride layer) were directly bonded to each other without SrTiO₃ film (oxide film) interposed therebetween. Further, the group III nitride composite substrates (Examples D2 to D10) each having the SrTiO₃ film (oxide film) to which at least one of elements Nb and La was added as an impurity had a larger bonding strength than the group III nitride composite substrate (Example D1) having the SrTiO₃ film (oxide film) to which no impurity was added.

It should be construed that embodiments and examples disclosed herein are by way of illustration in all respects, not by way of limitation. It is intended that the scope of the present invention is defined by claims, not by the description above, and encompasses all modifications and variations equivalent in meaning and scope to the claims.

### REFERENCE SIGNS LIST

1 group III nitride composite substrate; 10 support substrate; 20 oxide film; 30 group III nitride substrate; 30a group III nitride layer; 30b remaining group III nitride substrate; 30i ion implantation region; 30n main surface

## Claims

1. A group III nitride composite substrate comprising:
a support substrate (10);
an oxide film (20) formed on said support substrate (10); and
a group III nitride layer (30a) formed on said oxide film (20).

2. The group III nitride composite substrate according to claim 1, wherein said oxide film (20) is a film selected from the group consisting of a TiO₂ film and a SrTiO₃ film.

3. The group III nitride composite substrate according to claim 1, wherein an impurity is added to said oxide film (20).

4. The group III nitride composite substrate according to claim 3, wherein said impurity includes at least one element selected from the group consisting of Nb and La.

5. The group III nitride composite substrate according to claim 1, wherein said support substrate (10) is a group III nitride support substrate.

6. The group III nitride composite substrate according to claim 1, wherein said support substrate (10) is a sapphire support substrate.
